# EUROPEAN PATENT APPLICATION

(11) **EP 2 811 815 A1**
(43) Date of publication of application: **10.12.2014**
(21) Application number: 13170464.5
(22) Date of filing: 04.06.2013
(51) Int. Cl.: H05K 5/06

(54) **Volume compensation system**

(71) Applicant: Siemens Aktiengesellschaft, 80333 München (DE)
(72) Inventor: Kelly, Simon, Barrow-in-Furness, Cumbria LA14 4LQ (GB); Leach, Barry, Kendal, Cumbria LA9 5EF (GB); Smith, Jean-Pierre, Barrow-in-Furness, Cumbria LA14-5NW (GB)

(57) **Abstract**

An apparatus comprises a first housing and at least one volume compensation system connected to the first housing, wherein the at least one volume compensation system comprises a compensator housing and a member which is arranged such that it can move inside the compensator housing to compensate for changes in volume caused by changes in pressure and/or temperature inside and/or outside of the apparatus.

## Description

### Field of the invention

The present invention relates to the field of volume compensation systems, particularly a volume compensation system for a sealed housing such as an electrical distribution unit (EDU) or a retrievable electrical distribution unit (REDU). More specifically, the invention relates to a volume compensation system for use underwater.

### Background

EDUs can have a number of input connectors for connection to electrical input cables and a number of output connectors for connection to a number of electrical output cables. When such units are required for use underwater (e.g. under the sea) the EDU must, of course, be watertight. Due to the potentially large changes in pressure and temperature as the EDU is positioned underwater (often at great depths), a volume compensation system is used in the EDU to ensure that the pressure inside the EDU equals the pressure outside the EDU.

A known EDU for use underwater has two volume compensators which are located at opposite ends of the EDU. These compensators are bellows which flex to balance the pressures inside and outside of the EDU. This known EDU has six output connectors and one input connector , all of which are located on the same side of the EDU. However, due to the limits of volume compensation that can be provided by bellows, it is not possible to enlarge this design so that more output connectors can be provided; this would make the design too large and unwieldy.

Thus, the inventors of the present invention realised that there was a need for an improved volume compensation system which can compensate for larger variations in volume, such that larger EDUs may be provided with more output connectors.

### Summary

Accordingly, there is a need for an improved volume compensation system. This need is met by the features of the independent claims. The dependent claims describe embodiments of the invention.

According to a first aspect of the invention, there is provided an apparatus comprising a first housing and at least one volume compensation system connected to the first housing, wherein the at least one volume compensation system comprises a compensator housing and a member which is arranged such that it can move inside the compensator housing to compensate for changes in volume.

The changes in volume may be caused by changes in pressure and/or temperature inside and/or outside of the apparatus.

The volume may be that of a substance (or medium) contained in the apparatus and/or the volume contained by at least a part of the apparatus, e.g. at least a part of the first housing and volume compensation system. The compensation system may thus compensate volume changes of a substance which is at least partly filling the first housing, such as a liquid, gel or gas. Preferably, the substance is a liquid or a gel, in particular a dielectric liquid or gel.

Thus, according to the present invention, a volume compensation system comprises a compensator housing and a member which can move inside the compensator housing to compensate for changes in volume.

Since the member can move (e.g. change its position or location) inside the compensator housing, this means that it may accommodate greater changes in volume than the known bellows compensator, which cannot itself move, it merely changes shape, and can only accommodate smaller changes in volume.

As the member moves in the compensator housing, the volume contained by the first housing and the volume compensation system increases or decreases, and pressures inside and outside of the apparatus may be balanced. Such an arrangement can compensate for greater changes than the known bellows system.

The member may move slidably and/or translationally and/or longitudinally inside the compensator housing.

The member is preferably not attached to the compensator housing. However, the member is preferably arranged such that it is in fluid-tight engagement with the compensator housing as it moves within the housing. The entire member can preferably move freely inside the compensator housing, e.g. without any part of it being held in a single position.

The first housing is preferably a sealed or sealable housing, such that fluid inside the first housing cannot escape, and fluid outside the first housing cannot enter it.

The first housing may be sealed, at least in part, by the volume compensation system. For example, the first housing may comprise an opening into or over which the volume compensation system is sealingly engaged.

Ideally, there is a fluid-tight connection between the volume compensation system and the first housing.

The volume compensation system may comprise a flange, via which it may be connected to the first housing.

The volume compensation system (e.g. the compensator housing) may extend, e.g. partly, into the first housing.

The apparatus may comprise two or more volume compensation systems. This can provide compensation for greater changes in volume than a single volume compensation system.

In a preferred embodiment, the apparatus comprises two or more, preferably exactly two volume compensation systems.

The apparatus is preferably suitable for use underwater (e.g. under the sea). For example, the first housing could contain (or be suitable for containing) one or more components or devices which must not come in contact with water or conducting fluids, such as electrical components or devices.

The first housing could have any size and/or shape, and/or could be a part of a larger system, e.g. an underwater system.

The member should be in fluid-tight engagement with the compensator housing, to ensure that no fluid, e.g. water or a conducting fluid, can enter the first housing. In order to achieve such fluid-tight engagement, the member (or a circumference thereof) could be surrounded by a seal such as an O-ring or a gasket, for example, to provide a fluid-tight seal between the member and the compensator housing.

In a preferred embodiment, the volume compensation system comprises a piston or disc (the member), which is preferably arranged inside a cylinder (the compensator housing). Here, the term "cylinder" is intended to mean any housing in which a piston or disc may fit and move, and not necessarily a geometrical cylinder. In other words, the "cylinder" or compensator housing could have any shape such as a cuboid or other prism. However, a geometrical cylinder is preferred for the shape of the housing.

The member (e.g. piston or disc) preferably has a shape (cross-sectional shape) corresponding to that of the inner surface of the compensator housing (e.g. the cylinder). For example, the member may be substantially circular.

Preferably, the compensator housing has the same (i.e. a constant) internal cross-section along at least a substantial part of its longitudinal axis, preferably all of its longitudinal axis, or at least 70%, 75%, 80%, 85%, 90% or 95% thereof, such that the member may move inside the compensator housing, along the longitudinal axis thereof, whilst remaining in sealing engagement with an inner surface of the compensator housing.

The member is preferably rigid. Preferably, the shape of the member does not change during use, although its position may change. This rigidity helps to ensure that a fluid-tight seal between the member and the compensator housing can be maintained at all times.

The compensator housing may comprise a first chamber and a second chamber, the first and second chambers being separated by the member. Since the member can move inside the compensator housing, the sizes (i.e. the interior volumes) of these chambers may of course change during use.

Preferably, the first chamber is filled with a substance whose volume is affected by changes in pressure and/or temperature. For example, the volume of the substance may be affected by changes in pressure under a constant temperature, and/or by changes in temperature under a constant pressure. Such changes in volume would ideally cause the member to move within the compensator housing to compensate for changes in pressure and/or temperature, balancing the pressure on each side of the member (i.e. in the first and second chambers).

The substance could be an oil or a gel, for example. The oil and/or gel may be a dielectric.

The first chamber may for example be filled with a dielectric liquid, such as the above mentioned oil or gel.

The first chamber is preferably fluidically connected to the first housing (i.e. an interior volume thereof), at least a part of which may also be filled with the same substance as the first chamber.

The first chamber is preferably connected to the first housing in fluid-tight manner, i.e. such that fluid inside the first chamber and/or first housing cannot escape, and fluid outside the first chamber and/or first housing may not enter the first chamber and/or first housing.

The second chamber is preferably fluidically connected to the fluid surrounding (i.e. outside of) the sealed housing.

This arrangement means that the pressure inside the first housing may be kept in equilibrium, via the volume compensation system, with the pressure outside the first housing.

Preferably, the volume compensation system comprises a water-permeable cap. The cap may, for example, comprise one or more, preferably a plurality of, holes to allow water to pass therethrough. Such a cap can, in use, for example, allow water to enter the compensator housing (or more preferably the second chamber of the compensator housing) of the volume compensation system but not any solid particles which are larger than the porosity or one of more holes in the cap. This can help to prevent clogging of the volume compensation system and to ensure that the movement of the member inside the compensator housing is not hindered.

In a preferred embodiment, the water-permeable cap is made of silicone or another such oil-secreting material. Such a material is preferred because it can help to prevent calcius growth, which could clog the cap and prevent water from being able to permeate it.

The apparatus, or first housing thereof, may be or comprise an EDU, such as a retrievable EDU (REDU), for example.

The EDU may comprise at least one input connector and two or more output connectors.

The two or more output connectors may be arranged on a first side of the EDU and the at least one volume compensation system may be arranged on a second side of the EDU. The second side of the EDU may be opposite the first side of the EDU, for example. In such an arrangement, the overall volume of the EDU can be minimised, especially when compared with the prior art arrangement where the bellows are provided at two opposite ends of the EDU, which results in an EDU which is less thin.

In one embodiment, the two or more output connectors are arranged on a first side of the EDU and the input connector is arranged on a different side of the EDU. The different side of the EDU is preferably substantially perpendicular to the first side of the EDU. For example, the output connectors could be arranged on the front of the EDU and the input connector could be arranged on the bottom of the EDU. Such arrangements can make it easier to connect input cables without additional cabling being required.

In a preferred or usual embodiment, all of the connectors are arranged on the same side of the EDU (e.g. the front).

Of course, various other arrangements of the connectors on the EDU are also possible.

The EDU may comprise 2, 3, 4, 5, 6, 7, 8, 9, 10, 11 or more output connectors, for example.

According to another aspect of the invention, there is provided an apparatus comprising a first housing, such as an EDU, and a volume compensation system connected to the first housing, the volume compensation system comprising a piston or disc arranged in a cylinder, the piston or disc being movable within the cylinder to compensate for changes in volume, which may be caused by changes in pressure and/or temperature inside and/or outside of the apparatus.

The present invention also relates to underwater use of an apparatus comprising a first housing, such as an EDU, and at least one volume compensation system connected to the first housing, the at least one volume compensation system comprising a compensator housing and a member which is arranged such that it can move inside the compensator housing to compensate for changes in volume, which may be caused by changes in pressure inside and/or outside of the apparatus.

The present invention also relates to a method of manufacturing an apparatus as described above, the method comprising providing a first housing and at least one volume compensation system connected to the first housing, the at least one volume compensation system comprising a compensator housing and a member which is arranged such that it can move inside the compensator housing to compensate for changes in volume, which may be caused by changes in pressure and/or temperature inside and/or outside of the apparatus.

The present invention also relates to a method of using an apparatus as described above, the method comprising allowing the member to move in the compensator housing to compensate for changes in volume, which may be caused by changes in pressure and/or temperature inside and/or outside of the apparatus. The method may further comprise locating the apparatus underwater.

The aspects of the invention discussed above may comprise any of the features of the other aspects of the invention.

### Brief description of the drawings

Preferred embodiments of the invention will now be described by way of example only and with reference to the accompanying drawings, in which like reference numerals refer to like elements and in which:
Fig. 1 is a front perspective view with some parts cut away of an electrical distribution unit according to the invention;
Fig. 2 is a rear perspective view with some parts cut away of the electrical distribution unit according to the invention;
Fig. 3 is a cross-sectional view of a volume compensation system used in the electrical distribution unit according to the invention; and
Fig. 4 is a side cross-sectional view showing parts of the electrical distribution unit according to the invention.

### Detailed description

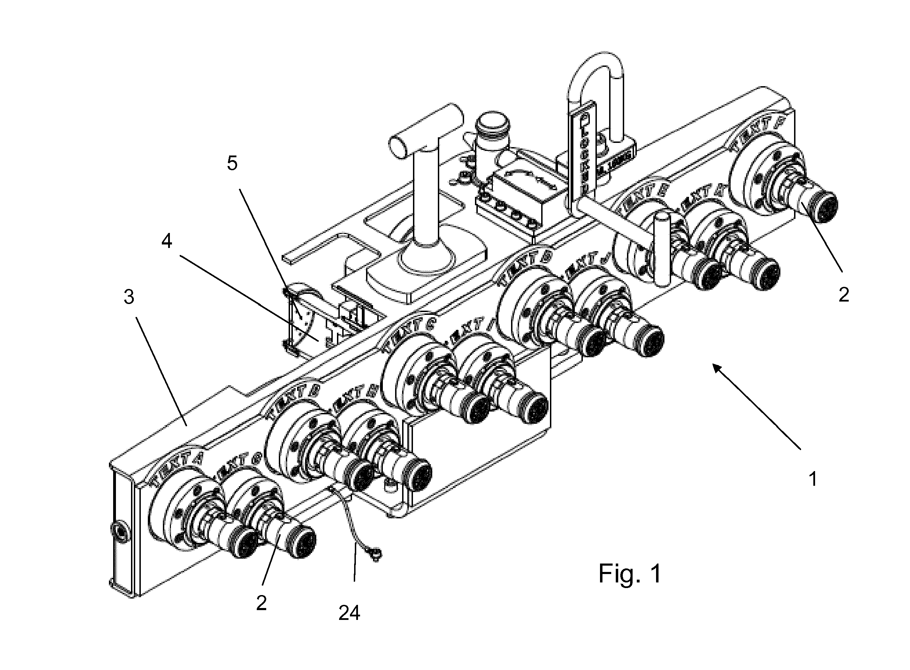

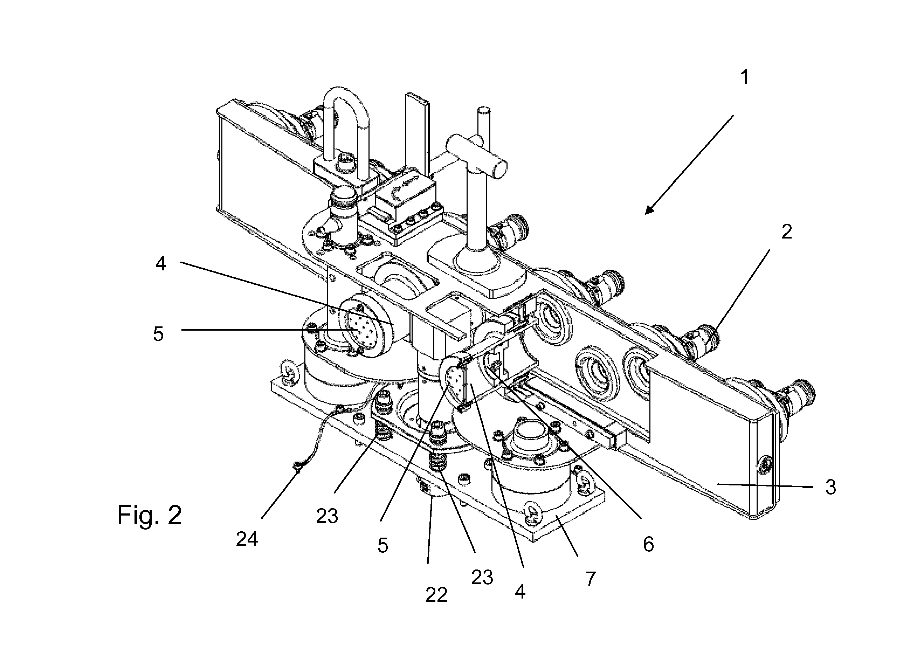

Figs. 1 and 2 show an EDU 1 according to an embodiment of the invention.

The EDU 1 is formed of a housing 3 to which eleven electrical output connectors 2 are attached. The output connectors 2 are arranged in two rows along a front surface of the housing 3. In alternative embodiments, other arrangements of the output connectors 2 are of course possible.

Two volume compensation systems 4 are arranged on a back surface of the housing 3, behind the output connectors 2. The volume compensation systems 4 are described in more detail below.

The EDU 1 has an input connector 22 arranged to project downwardly to engage with a mating connector. A base plate 7 is connected to the rest of the EDU via four springs 23.

The EDU 1 can be connected via the input connector 22 to an electrical input cable (not shown). This can then be connected to one or more electrical output cables (also not shown) via the output connectors 2

An earth connection 24 is connected to the input connector 22.

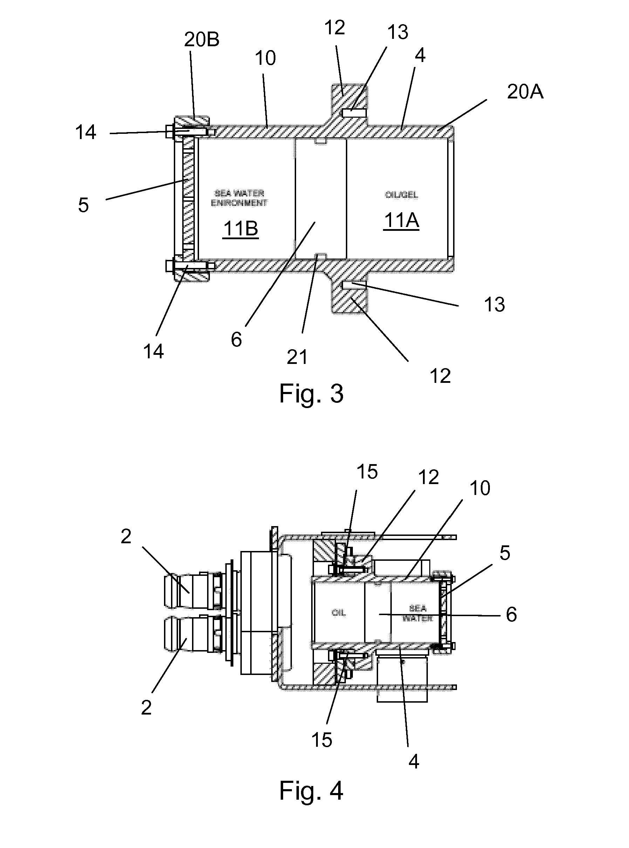

As shown in more detail in Figs. 3 and 4, the volume compensation systems 4 are each formed of a cylinder 10 in which is located a compensator disc 6. The cylinder and the compensator disc are made of stainless steel. The compensator disc 6 can move longitudinally within the cylinder 10. The circumference of the compensator disc 6 fits inside the inner circumference of the cylinder 10.

The circumference of the compensator disc 6 is surrounded by an O-ring 21 to ensure that the compensator disc 6 fits tightly inside the cylinder 10, with no space between. In an alternative embodiment, a gasket is used in place of the O-ring 21. The O-ring 21 or gasket allows the compensator disc 6 to move in the cylinder 10 but without allowing any fluid to pass from one side of the compensator disc 6 to the other (i.e. no leaks).

The cylinder 10 has a first end 20A which is located adjacent the rest of the EDU 1. The second end 20B of the cylinder 10 protrudes away from the rest of the EDU 1.

A first chamber 11A at the first end 20A of the cylinder 10, on a first side of the compensator disc 6, is filled with oil. In an alternative embodiment, the first chamber 11A is filled with gel.

A second chamber 11B at the second end 20B of the cylinder 10, on a second side of the compensator disc 6, is filled, in use, with sea water.

A water-permeable cap 5 is provided over the second end 20B of the cylinder 10. The water-permeable cap 5 has one or more small holes in it which allow sea water to enter the second chamber 11B but prevent any solid particles which are larger than the size of the holes from entering. This helps to prevent clogging in the cylinder 10 and ensures that the compensator disc 6 is not hindered from moving inside the cylinder 10.

The cap 5 is made of a material which discourages calcius growth. The material can be silicone, for example. This means that hole(s) in the cap 5 do not get clogged and water can pass easily through them.

The cap 5 is fastened to the cylinder 10 with screws 14.

As the compensator disc 6 moves longitudinally inside the cylinder 10, the sizes of the chambers 11A and 11B will change accordingly.

The volume compensation system 4 has a radially extending flange 12 with holes 13 which allow it to be fastened to the EDU 1 with screws 15.

The volume compensation system 4 is based on a chamber 11A which is entirely filled with either an oil or a gel substance (i.e. without any gas or air present). This oil or gel substance is affected by temperature and pressure. The chamber 11A containing the oil or gel substance is located in the first end 20A of the cylinder 10 and also extends into the housing 3 of the EDU 1.

The oil or gel substance is affected by temperature and/or pressure. When the temperature of the oil or gel substance increases, the substance expands; when it is cooled it contracts. Having the oil or gel substance in a vacuum chamber therefore results in the creation of a positive pressure difference when its temperature rises and a negative pressure difference when it cools.

In order to compensate for the change in pressure created by the expanding or contracting oil or gel substance, the compensator disc 6 moves in the cylinder 10 to equalise the pressure on either side of the disc 6. The compensator disc 6 moves along the cylinder 10 until the pressure inside the first chamber 11A equals the external pressure (which is the same as the pressure in the second chamber 11B).

With the volume compensation system 4, the EDU 1 can withstand great depths under the ocean due to pressure equilibrium. In order to overcome or compensate for the hydrostatic pressure acting on the EDU 1, the compensator disc 6 moves in the cylinder 10 until the internal pressure equals the external pressure.

## Claims

1. An apparatus comprising:
a first housing; and
at least one volume compensation system connected to the first housing for compensating volume changes of a substance at least partly filling the first housing;
wherein the at least one volume compensation system comprises a compensator housing and a member which is arranged such that it can move inside the compensator housing to compensate for changes in volume,
wherein the member is in fluid-tight engagement with the compensator housing, and
wherein the member can move slidably and translationally inside the compensator housing.

2. An apparatus as claimed in claim 1, wherein the first housing comprises an opening into or over which the volume compensation system is sealingly engaged.

3. An apparatus as claimed in any preceding claim, the apparatus comprising two or more volume compensation systems.

4. An apparatus as claimed in any preceding claim, wherein the member is surrounded by a seal.

5. An apparatus as claimed in any preceding claim, wherein the member is a piston or disc; and/or the compensator housing is a cylinder.

6. An apparatus as claimed in any preceding claim, wherein the compensator housing has the same internal cross-section along at least a substantial part of its longitudinal axis, preferably all of its longitudinal axis, or at least 70%, 75%, 80%, 85%, 90% or 95% thereof.

7. An apparatus as claimed in any preceding claim, wherein the member is rigid.

8. An apparatus as claimed in any preceding claim, wherein the compensator housing comprises a first chamber and a second chamber, the first and second chambers being separated by the member.

9. An apparatus as claimed in claim 8, wherein the first chamber is filled with a liquid or gel.

10. An apparatus as claimed in any of the preceding claims, wherein the volume compensation system comprises a water-permeable cap which preferably comprises at least one, two, or a plurality of holes to allow water to pass therethrough when the apparatus is installed subsea.

11. An apparatus as claimed in claims 8 or 9 and in claim 10, wherein the cap is configured to, in use, allow water to enter the second chamber of the compensator housing of the volume compensation system but not any solid particles which are larger than the porosity of the one or more holes in the cap.

12. An apparatus as claimed in any preceding claim, wherein the apparatus, or first housing thereof, is or comprises an electrical distribution unit.

13. A method of manufacturing an apparatus with at least one volume compensation system, the method comprising providing a first housing and at least one volume compensation system connected to the first housing, wherein the at least one volume compensation system comprises a compensator housing and a member which is arranged such that it can move inside the compensator housing to compensate for changes in volume, wherein the member is in fluid-tight engagement with the compensator housing and wherein the member can move slidably and translationally inside the compensator housing.

14. A method of using an apparatus as claimed in any of claims 1 to 12, the method comprising allowing the member to move in the compensator housing to compensate for changes in volume.

15. Use of an apparatus as claimed in any of claims 1 to 12 underwater.
